# EUROPEAN PATENT SPECIFICATION

(11) **EP 2 608 645 B1**
(45) Date of publication and mention of the grant of the patent: **22.04.2015**
(21) Application number: 11194476.5
(22) Date of filing: 20.12.2011
(51) Int. Cl.: H05K 7/14

(54) **Mounting assembly for mounting electronic equipment to a support**
Montagevorrichtung zum Anbringen von elektronischen Geräten an eine Stütze
Ensemble de montage pour assembler un équipement électronique sur un support

(43) Date of publication of application: 26.06.2013
(73) Proprietor: EATON Industries Manufacturing GmbH, 1110 Morges (CH)
(72) Inventor: McDowall, Gregor, 1143 Apples (CH)
(74) Representative: Leadbetter, Benedict

(56) References cited:
- WO-A1-2009/105068
- WO-A2-2007/054194
- US-A1- 2008 258 026
- US-A1- 2010 127 141

## Description

This invention relates to a mounting assembly for mounting electronic equipment to a support. The mounting assembly comprises a clamp element having a clamping mechanism for clamping the clamp element to said electronic equipment. The electronic equipment can be particularly a powered distribution unit for distributing electric power to several loads, e.g. servers, in a server rack.

Power distribution units for a server environment distributing electronic power to several servers and other computer modules typically have a chassis and a cover with a significant number of electric connectors and other elements such as switches and displays. The power distribution units can have a significant length and have to be mounted to a support, in particular a frame of a server rack. The power distribution unit comprises usually a chassis made of an extruded profile containing all the connectors and displays. There are many variations in mounting types and orientations that must be accommodated, such as a horizontal or a vertical orientation of the chassis. Usually the chassis is mounted to the rack frame by mounting feet which are clipped to the power distribution unit chassis and can be bolted to the rack frame. Horizontal and vertical mounting must be accommodated in one part wherein the mounting feet can be clipped to the chassis in two directions, i.e. a horizontal and a vertical direction. For altering the orientation of the mounting feet they have to be disassembled from the chassis. US20100127141A1 discloses an apparatus for the mounting of a zero unit PDU to a rack having mounting rails.

Object of the invention is to provide a mounting assembly for mounting an electronic equipment such as a power distribution unit in different orientations, wherein the mounting assembly can be easily moved between different mounting orientations of the electronic equipment.

The object is solved by a mounting assembly for mounting electronic equipment to a support comprising: a clamp element having a clamping mechanism for clamping the clamp element to said electronic equipment, wherein a base element is pivotally connected to said clamp element which base element comprises attachment means for mounting the base element to said support.

The advantage of the mounting assembly according to the invention is that if the orientation of the mounting assembly has to be changed the clamp element has not to be disassembled from the electronic equipment. It is only necessary to rotate the base element around a pivot axis.

According to a preferred embodiment the clamping mechanism comprises a pair of clamping arms opposite to each other for clamping a chassis of the electronic equipment between said clamping arms. Hence, the clamp element can be clipped onto the chassis without using a tool which enables an easy assembly and disassembly of the mounting assembly from the electronic equipment.

Each clamping arm can have a protrusion for engagement with a recess of the chassis. In particular the clamp element has a U-shaped cross-section with a bottom wall wherein the clamping arms are projecting from said bottom wall. The clamping arms extend along two opposite edges of the bottom wall parallel to each other in an axial direction. The clamping element is designed such that it can be clamped onto a chassis which is made of an extrusion molded profile wherein the chassis has side walls with recesses extending along in axial direction. The clamp element, therefore, can be clamped to any axial position along the extension of the chassis.

In a preferred embodiment the protrusion of each clamping arm extends over the entire axial length of the clamping arm.

The clamping arms can be provided at least with one cut-out along their axial length in order to provide a design which makes it possible to engage a tool such like a screwdriver for bending the clamping arms outwardly out of the recesses of the chassis for disconnecting the clamp element from the chassis.

The clamp element is preferably made of sheet metal in order to provide a sufficient clamp force avoiding slipping of the chassis relative to the clamp element. Further measurements for avoiding slipping can be at least one tine within the clamp element projecting from the bottom wall having a cutting edge orientated in axial direction for engaging the chassis. If the clamp element and the chassis are moved relative to each other the cutting edge cuts into the material of the chassis avoiding further slipping. The chassis can be made of extrusion molded plastic or aluminum wherein if the chassis is made of aluminum the tines cut into a powder coating of the chassis.

In order to avoid slipping in the two possible axial directions at least two tines are provided, orientated opposite to each other.

The clamp element can have at least one spring arm projecting from the bottom wall in the direction opposite to the clamping arms wherein the spring arm is supported against an alignment edge of the base element. The spring arm supported against the alignment edge of the base element defines a distinct rotational position between the clamping element and the base element. It can also provide for a support against rotation out of this distinct rotational position. The spring arm can be supported against an outer circumferential edge of the base element or against an edge of an aperture in the base element. For further rotating the base element relative to the clamp element the spring arm can be pushed out of engagement with the alignment edge in a position in which the spring arm is flush with the bottom wall. In this position the base element can be rotated relative to the clamp element until another distinct rotational position has been reached and the spring arm flips back into its projecting position engaging another alignment edge of the base element. In a preferred embodiment the distinct rotational positions are orientated 90° to each other.

A rotational connection between the clamp element and the base element can be provided by a pivot, comprising a pivot bore within the clamp element and a pivot pin on the base element wherein the pivot pin has an undercut for engagement with the pivot bore. The assembly of the mounting assembly therefore is accomplished just by clipping the clamp element onto the pivot pin of the base element. Alternatively, the pivot pin can be formed as a cylindrical boss in the manner of a rivet. After assembling the clamp element onto the pivot pin, the end of the pivot pin is crimped forming a pivot head. The pivot head constitutes an undercut engaging the pivot bore.

In particular, the base element is made of sheet metal or of an electrically insulating material such as molded plastic in order to realize that the electronic equipment is electrically insulated against the support.

The foregoing and other features and advantages of this invention will become more readily apparent and understood when reading the following description in conjunction with the accompanying drawings.
- Figure 1: is a perspective view of two mounting assemblies mounted to a chassis of an electric equipment,
- Figure 2: is a perspective view of the clamp element and
- Figure 3: is a perspective view of the base element.

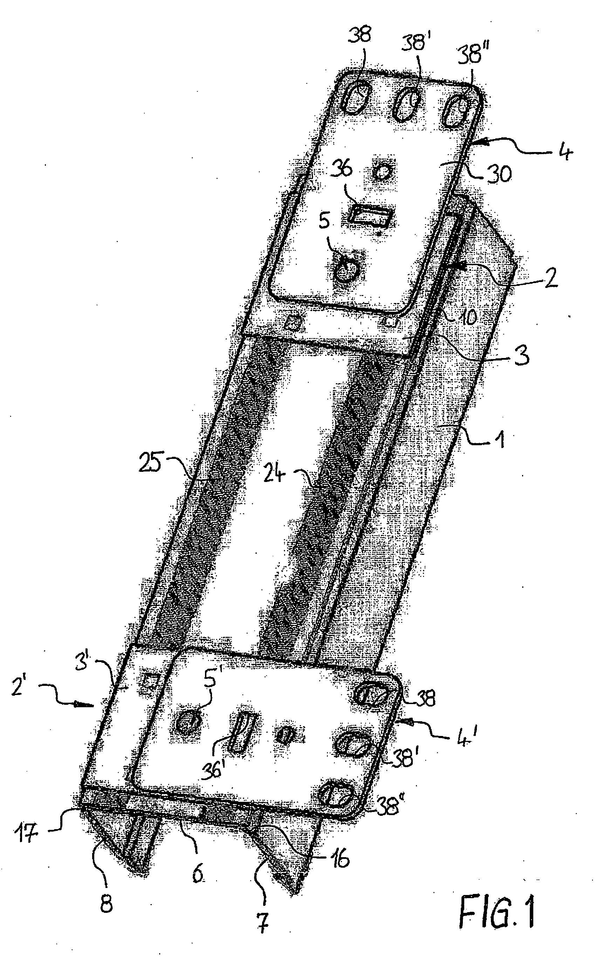

Figure 1 show the perspective view of a chassis 1 of an electric equipment such as a power distribution unit for a computer server rack. Two mounting assemblies 2, 2' are mounted onto the chassis 1. The two mounting assemblies 2, 2' shown in Figure 1 are identical. Each mounting assembly 2, 2' comprises a clamp element 3 which is clamped to the chassis 1 and a base element 4. The base element 4 is pivotally connected to the clamp element 3 via a pivot 5.

The chassis 1 is an extrusion molded profile having a back wall 6 and two side walls 7, 8. The clamp element 3 is clamped to the outside of the back wall 6.

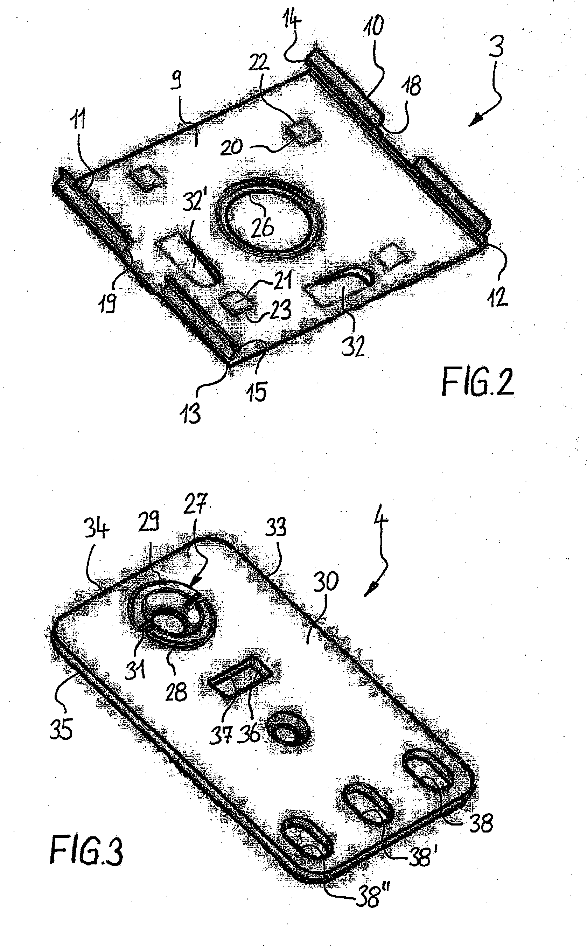

The clamp element 3 is shown in Figure 2 in detail. The base element 4 is shown in Figure 3. Figures 2 and 3 will be described together with Figure 1.

As can be seen especially in Figure 2 the clamp element 3 has a U-shaped profile with a bottom wall 9. The bottom wall 9 is held against the back wall 6 of the chassis 1 if mounted to this chassis 1. The clamp element 3 further comprises two clamping arms 10, 11 which extend along opposite edges 12, 13 of the bottom wall 9. The clamping arms 10, 11 are orientated parallel to each other and have protrusions 14, 15 protruding inwardly and facing each other. In assembled condition the protrusions 14, 15 engage recesses 16, 17 of the chassis 1 which are provided in the side walls 7, 8 near the back wall 6. The recesses 16, 17 are in the form of grooves along the entire length of the chassis 1 so that the clamp element 3 can be clamped to the chassis 1 at any axial position.

Each clamping arm 10, 11 has a cut-out 18, 19 dividing each clamp arm 10, 11 into two clamp arm parts. The cut-outs 18, 19 facilitate to disassemble the clamp element 3 from the chassis 1 which a tool such as a screwdriver which can be engaged to the clamping arms 10, 12 through the cut-outs 18, 19.

The clamp element 3 is provided with two tines 20, 21 which are stamped or embossed into the bottom wall 9 and project from the bottom wall 9 in the same direction as the clamping arms 10, 11. Each tine 20, 21 has a cutting edge 22, 23 orientated in opposite directions and in axial direction of the chassis 1. The chassis 1 has embossed tracks 24, 25 into which the cutting edges 22, 23 of the tines 20, 21 may engage or cut for preventing the chassis 1 slipping relative to the mounting assembly.

The pivot 5 comprises a bore 26 within the bottom wall 9 of the clamp element 3. Further, the pivot 5 comprises a tubular pivot pin 27 projecting from the base element 4 in direction towards the clamp element 3. The pivot pin 27 has an under-cut 28 forming an annular groove between a pivot head 29 and a plate element 30 of the base element 4. The pivot pin 27 further is provided with a slot 31 to enable the pivot pin 27 to be bend radially together for mounting the clamp element 3 onto the pivot pin 27. In an assemblied condition the pivot pin 27 reaches through the bore 26 of the clamp element 3.

In order to realize distinct rotational positions of the base element 4 relative to the clamp element 3 the clamp element 3 comprises a spring arm 32, which is cut-out of the bottom wall 9 of the clamp element 3. The spring arm is bend such that it projects from the bottom wall 9 in a opposite direction than the clamping arms 10, 11. The spring arm 32 can be supported against one of the outer edges 33, 34, 35 of the base element 4 having the function of an alignment edge. Depending on the rotational position, the spring arm 32 will support against one of the outer edges 33, 34, 35 Further, the base element 4 can be provided with an aperture 36 having at least one alignment edge 37 for supporting the spring arm 32. For rotating the base element 4 out of one of the distinct rotational positions the spring arm 32 can be pushed back into a position in which the spring arm 32 is flush with the bottom wall 9. In this position of the spring arm 32 it is not supported anymore against one of the edges 33, 34, 35, 37 so that the base element 4 can be rotated relative to the clamp element 3 until the base element 4 reaches another distinct position in which the spring arm 32 flips back into a projecting position and in which the spring arm 32 is supported against another one of the edges 33, 34, 35, 37.

In addition the base element 4 comprises attachment holes 38 as attachment means for attaching the base element 4 to a support such as a server rack frame via bolts.
- 1: chassis
- 2: mounting assembly
- 3: clamp element
- 4: base element
- 5: pivot
- 6: back wall
- 7: side wall
- 8: side wall
- 9: bottom wall
- 10: clamping arm
- 11: clamping arm
- 12: edge of bottom wall
- 13: edge of bottom wall
- 14: protrusion
- 15: protrusion
- 16: recess
- 17: recess
- 18: cut-out
- 19: cut-out
- 20: tine
- 21: tine
- 22: cutting edge
- 23: cutting edge
- 24: embossed track
- 25: embossed track
- 26: pivot bore
- 27: pivot pin
- 28: under-cut
- 29: pivot head
- 30: plate element
- 31: slot
- 32: spring arm
- 33: outer edge
- 34: outer edge
- 35: outer edge
- 36: aperture
- 37: alignment edge
- 38: attachment hole

## Claims

1. Mounting assembly (2) for mounting to a support electronic equipment (1), such as a powered distribution unit for distributing electric power to several loads, comprising:
a clamp element (3) having a clamping mechanism (10,11) for clamping the clamp element (3) to said electronic equipment (1), a base element (4) pivotally connected to said clamp element (3) which base element (4) comprises attachment means (38) for mounting the base element (4) to said support, **characterized in that** a pivot (5) is provided for pivotally connecting the base element (4) to the clamp element (3), the pivot (5) comprising a pivot bore (26) within the clamp element (3) and a pivot pin (27) on the base element, the pivot pin (27) having an undercut (28) for engagement with the pivot bore (26).

2. Mounting assembly according to claim 1, **characterized in that** the clamping mechanism comprises a pair of clamping arms (10,11) opposite to each other for clamping a chassis (1) of the electronic equipment between said clamping arms (10, 11).

3. Mounting assembly according to claim 2, **characterized in that** each clamping arm (10, 11) has a protrusion (14, 15) for engagement with a recess (16, 17) of the chassis (1).

4. Mounting assembly according to any one of claims 2 or 3, **characterized in that** the clamp element (3) has a U-shaped cross-section with a bottom wall (9) and the clamping arms (10, 11) project from said bottom wall (9) and that the clamping arms (10, 11) extend along two opposite edges (12, 13) of the bottom wall (9) parallel to each other in an axial direction.

5. Mounting assembly according to claim 4, **characterized in that** said protrusion (14, 15) of each clamping arm (10, 11) extends over the entire axial length of the clamping arm (10, 11).

6. Mounting assembly according to any one of claims 2 to 5, **characterized in that** each clamping arm (10, 11) has along its axial length at least one cut-out (18, 19) for a tool engagement.

7. Mounting assembly according to any one of the preceding claims, **characterized in that** the clamp element (3) is made of sheet metal.

8. Mounting assembly according to any one of the preceding claims, **characterized in that** the clamp element (3) has at least one tine (20, 21) projecting from the bottom wall (9) having a cutting edge (22, 23) orientate in axial direction for engaging the chassis (1).

9. Mounting assembly according to claim 8, **characterized in that** at least two tines (20, 21) are provided, orientated opposite to each other.

10. Mounting assembly according to any one of claims 4 to 9, **characterized in that** the clamp element (3) has at least one spring arm (32) projecting from the bottom wall (9) in a direction opposite to the clamping arms (10, 11) which spring arm (32) is supported against an alignment edge (33, 34, 35, 37) of the base element (4).

11. Mounting assembly according to claim 11, **characterized in that** the pivot pin (27) is in the form of a cylindrical boss having a pivot head (29) for engagement with the pivot bore (26).

12. Mounting assembly according to any one of the preceding claims, **characterized in that** the base element (4) is made of sheet metal or of an electrically insulating material, in particular of molded plastic.

## Patentansprüche

1. Montagebaugruppe (2) für die Montage elektronischer Ausrüstung (1), z. B. einer Stromverteilereinheit für die Verteilung elektrischer Energie an mehrere Lasten, auf einem Träger, umfassend:
ein Klemmelement (3) mit einem Klemmmechanismus (10, 11) zum Festklemmen des Klemmelements (3) an der elektronischen Ausrüstung (1), ein Basiselement (4), das gelenkig mit dem Klemmelement (3) verbunden ist, wobei das Basiselement (4) Befestigungsmittel (38) zur Montage des Basiselements (4) an dem Träger umfasst, **dadurch gekennzeichnet, dass** zur gelenkigen Verbindung des Basiselements (4) mit dem Klemmelement (3) ein Drehgelenk (5) vorgesehen ist, wobei das Drehgelenk (5) eine Gelenkbohrung (26) innerhalb des Klemmelements (3) und einen Gelenkzapfen (27) an dem Basiselement umfasst, wobei der Gelenkzapfen (27) eine Unterschneidung (28) zum Eingriff mit der Gelenkbohrung (26) aufweist.

2. Montagebaugruppe nach Anspruch 1, **dadurch gekennzeichnet, dass** der Klemmmechanismus ein Paar einander gegenüberliegender Klemmarme (10, 11) zum Festklemmen eines Gehäuses (1) der elektronischen Ausrüstung zwischen den Klemmarmen (10, 11) umfasst.

3. Montagebaugruppe nach Anspruch 2, **dadurch gekennzeichnet, dass** jeder Klemmarm (10, 11) einen Vorsprung (14, 15) für den Eingriff mit einer Aussparung (16, 17) des Gehäuses (1) aufweist.

4. Montagebaugruppe nach einem der Ansprüche 2 oder 3, **dadurch gekennzeichnet, dass** das Klemmelement (3) einen U-förmigen Querschnitt mit einer unteren Wand (9) aufweist und die Klemmarme (10, 11) von der unteren Wand (9) abstehen und dass sich die Klemmarme (10, 11) entlang zweier gegenüberliegender Kanten (12, 13) der unteren Wand (9) parallel zueinander in einer axialen Richtung erstrecken.

5. Montagebaugruppe nach Anspruch 4, **dadurch gekennzeichnet, dass** sich der Vorsprung (14, 15) jedes Klemmarms (10, 11) über die gesamte axiale Länge des Klemmarms (10 11) erstreckt.

6. Montagebaugruppe nach einem der Ansprüche 2 bis 5, **dadurch gekennzeichnet, dass** jeder Klemmarm (10, 11) entlang seiner axialen Länge wenigstens eine Ausnehmung (18, 19) für den Eingriff eines Werkzeugs aufweist.

7. Montagebaugruppe nach einem der vorangehenden Ansprüche, **dadurch gekennzeichnet, dass** das Klemmelement (3) aus Blech gefertigt ist.

8. Montagebaugruppe nach einem der vorangehenden Ansprüche, **dadurch gekennzeichnet, dass** das Klemmelement (3) wenigstens eine von der unteren Wand (9) abstehende Zinke (20, 21) aufweist, deren Schneidkante (22, 23) in axialer Richtung ausgerichtet ist, um in das Gehäuse (1) einzugreifen.

9. Montagebaugruppe nach Anspruch 8, **dadurch gekennzeichnet, dass** wenigstens zwei Zinken (20, 21) vorgesehen sind, die einander entgegengesetzt ausgerichtet sind.

10. Montagebaugruppe nach einem der Ansprüche 4-9, **dadurch gekennzeichnet, dass** das Klemmelement (3) wenigstens einen Federarm (32) aufweist, der in einer den Klemmarmen (10, 11) entgegengesetzten Richtung von der unteren Wand (9) absteht, wobei der Federarm (32) gegen eine Ausrichtungskante (33, 34, 35, 37) des Basiselements (4) abgestützt ist.

11. Montagebaugruppe nach Anspruch 11, **dadurch gekennzeichnet, dass** der Gelenkzapfen (27) die Form einer zylindrischen Erhebung mit einem Gelenkkopf (29) zum Eingriff mit der Gelenkbohrung (26) aufweist.

12. Montagebaugruppe nach einem der vorangehenden Ansprüche, **dadurch gekennzeichnet, dass** das Basiselement (4) aus Blech oder aus einem elektrisch isolierenden Material, insbesondere aus geformtem Kunststoff, gefertigt ist.

## Revendications

1. Ensemble de montage (2) pour monter sur un support un équipement électronique (1), tel qu'une unité de distribution électrique pour distribuer de l'énergie électrique à diverses charges, comprenant :
un élément de blocage (3) ayant un mécanisme de blocage (10, 11) pour bloquer l'élément de blocage (3) sur ledit équipement électronique (1), un élément de base (4) raccordé à pivotement audit élément de blocage (3), lequel élément de base (4) comprend des moyens de fixation (38) pour monter l'élément de base (4) sur ledit support, **caractérisé en ce qu'**un pivot (5) est ménagé pour raccorder à pivotement l'élément de base (4) à l'élément de blocage (3), le pivot (5) comprenant un alésage de pivot (26) dans l'élément de blocage (3) et une broche pivot (27) sur l'élément de base, la broche pivot (27) présentant une dépouille (28) destinée à s'engager sur l'alésage de pivot (26).

2. Ensemble de montage selon la revendication 1, **caractérisé en ce que** le mécanisme de blocage comprend une paire de bras de blocage (10, 11) opposés l'un à l'autre pour bloquer un châssis (1) de l'équipement électronique entre lesdits bras de blocage (10, 11).

3. Ensemble de montage selon la revendication 2, **caractérisé en ce que** chaque bras de blocage (10, 11) présente une saillie (14, 15) destinée à s'engager dans un évidement (16, 17) du châssis (1).

4. Ensemble de montage selon l'une quelconque des revendications 2 ou 3, **caractérisé en ce que** l'élément de blocage (3) présente une section transversale en forme de U avec une paroi inférieure (9) et les bras de blocage (10, 11) font saillie de ladite paroi inférieure (9) et **en ce que** les bras de blocage (10, 11) s'étendent le long de deux bords opposés (12, 13) de la paroi inférieure (9) parallèlement l'un à l'autre dans une direction axiale.

5. Ensemble de montage selon la revendication 4, **caractérisé en ce que** ladite saillie (14, 15) de chaque bras de blocage (10, 11) s'étend sur toute la longueur axiale du bras de blocage (10, 11).

6. Ensemble de montage selon l'une quelconque des revendications 2 à 5, **caractérisé en ce que** chaque bras de blocage (10, 11) présente sur sa longueur axiale au moins une découpe (18, 19) pour y engager un outil.

7. Ensemble de montage selon l'une quelconque des revendications précédentes, **caractérisé en ce que** l'élément de blocage (3) est constitué de métal en feuille.

8. Ensemble de montage selon l'une quelconque des revendications précédentes, **caractérisé en ce que** l'élément de blocage (3) présente au moins une dent (20, 21) faisant saillie de la paroi inférieure (9) et ayant un bord de coupe (22, 23) orienté dans la direction axiale pour s'engager sur le châssis (1).

9. Ensemble de montage selon la revendication 8, **caractérisé en ce qu'**il est prévu au moins deux dents (20, 21) orientées l'une en regard de l'autre.

10. Ensemble de montage selon l'une quelconque des revendications 4 à 9, **caractérisé en ce que** l'élément de blocage (3) présente au moins un bras à ressort (32) faisant saillie de la paroi inférieure (9) dans une direction opposée aux bras de blocage (10, 11), ledit bras de ressort (32) étant supporté contre un bord d'alignement (33, 34, 35, 37) de l'élément de base (4).

11. Ensemble de montage selon la revendication 11, **caractérisé en ce que** la broche pivot (27) se présente sous la forme d'un bossage cylindrique ayant une tête de pivot (29) destinée à s'engager sur l'alésage de pivot (26).

12. Ensemble de montage selon l'une quelconque des revendications précédentes, **caractérisé en ce que** l'élément de base (4) est constitué de métal en feuille ou d'un matériau isolant de l'électricité, en particulier d'une matière plastique moulée.
